(19) Europäisches Patentamt / European Patent Office / Office européen des brevets

(11) **EP 4 490 920 B1**

(12) **EUROPEAN PATENT SPECIFICATION**

(45) Date of publication and mention
of the grant of the patent:
**18.02.2026  Bulletin 2026/08**

(21) Application number: **23712137.1**

(22) Date of filing: **03.03.2023**

(51) International Patent Classification (IPC):
**H04S 7/00** *(2006.01)*    **H04S 1/00** *(2006.01)*
**G10L 21/0272** *(2013.01)*

(52) Cooperative Patent Classification (CPC):
**H04S 7/30;** G10L 21/0272; H04S 1/002

(86) International application number:
**PCT/US2023/063717**

(87) International publication number:
**WO 2023/172852 (14.09.2023 Gazette 2023/37)**

(54) **TARGET MID-SIDE SIGNALS FOR AUDIO APPLICATIONS**

MITTEN-SEITEN-ZIELSIGNALE FÜR AUDIOANWENDUNGEN

SIGNAUX CENTRAUX-LATERAUX CIBLES POUR APPLICATIONS AUDIO

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **09.03.2022  US 202263318226 P
08.07.2022  EP 22183794
08.11.2022  US 202263423786 P**

(43) Date of publication of application:
**15.01.2025  Bulletin 2025/03**

(73) Proprietor: **Dolby Laboratories Licensing
Corporation
San Francisco, CA 94103 (US)**

(72) Inventors:
• **MASTER, Aaron Steven
San Francisco, California 94103 (US)**
• **LU, Lie
San Francisco, California 94103 (US)**

(74) Representative: **Dolby International AB
Patent Group Europe
77 Sir John Rogerson's Quay
Block C
Grand Canal Docklands
Dublin, D02 VK60 (IE)**

(56) References cited:
**WO-A2-2021/252795    US-A1- 2006 050 898
US-B1- 7 970 144**

• SEBASTIAN KRAFT ET AL: "STEREO SIGNAL
SEPARATION AND UPMIXING BY MID-SIDE
DECOMPOSITION IN THE FREQUENCY-
DOMAIN", PROC. OF THE 18 TH INT, 1 January
2015 (2015-01-01), XP055324212, Retrieved from
the Internet <URL:http://www.ntnu.edu/
documents/1001201110/1266017954/
DAFx-15_submission_9.pdf> [retrieved on
20161129]
• BERTRAND FATUS: "Parametric Coding for
Spatial Audio", MASTER THESIS, 27 January
2016 (2016-01-27), pages 1 - 70, XP055709902,
Retrieved from the Internet <URL:https://www.
diva-portal.org/smash/get/diva2:1057217/
FULLTEXT01.pdf> [retrieved on 20200630]

**EP 4 490 920 B1**

**Description**

CROSS-REFERENCE TO RELATED APPLICATION

This application claims priority of the following priority application: US provisional application 63/318,226, filed 09 March 2022, US provisional application 63/423,786, filed 08 November 2022, and European Patent application no. 22183794.1, filed 08 July 2022.

TECHNICAL FIELD OF THE INVENTION

The present invention relates to source separation, signal enhancement, and signal processing. The present invention further relates to a method for extracting target mid and side audio signals from a stereo audio signal. The present invention further relates to a processing device employing the aforementioned method.

BACKGROUND OF THE INVENTION

In the field of audio processing, audio source separation is an important in several applications. In one simple application, a separated speech audio signal is kept or provided with additional gain whereas the background audio signal is omitted or attenuated relative to the speech audio signal. This can enhance the intelligibility of the speech audio signal.

In audio source separation, the signal of interest which is targeted for estimation or extraction is termed the target signal. The target signal is not limited to speech and may be any general audio signal (such as a musical instrument) or even a plurality of audio signals which are to be separated from an audio mix comprising noise and/or additional audio signals which are not of interest.

For stereo audio signals which comprise two audio signals, associated with a left and right audio channel respectively, one method of processing, which also implicitly performs some source separation, is to extract mid and side audio signals from the left and right audio signals, wherein the mid and side audio signals are proportional to the sum and difference of the left and right audio signals respectively. The mid signal will emphasize audio components that are equal in magnitude and in-phase between the left and right audio signals, whereas the side audio signal will attenuate or eliminate such signals. Accordingly, calculation of mid and side signals from the left and right audio signals constitutes an efficient method for respectively boosting or attenuating in-phase center-panned sources. Mid and side signals can further be converted back to left and right (conventional stereo) audio signals.

To the extent that a center-panned source is of interest, it is noted that source separation has been implicitly performed: the mid signal will contain this source while the side signal will not. The side audio signal will comprise mainly potentially uninteresting background audio signals which could be attenuated or omitted to enhance the intelligibility of the center panned in-phase audio source.

A drawback of conventional mid and side signal calculation is that when the desired audio source is not center-panned, the implicit source separation based on mid/side audio signal separation fails. To address this, specific mid and side signal calculation techniques have been developed for stereo audio signals with specific panning properties, techniques which are capable of successfully targeting stationary non-center panned audio sources. See e.g. Stereo Music Source Separation via Bayesian Modeling, by Master, Aaron, Ph.D. dissertation, Stanford University, 2006.

Patent publication WO 2021/252795 A2 describes a method for audio source separation that involves obtaining softmask values for frequency bins of time-frequency tiles.

Sebastian Kraft ET AL: "STEREO SIGNAL SEPARATION AND UPMIXING BY MID-SIDE DECOMPOSITION IN THE FREQUENCY-DOMAIN", Proc. of the 18th Int. Conference on Digital Audio Effects (DAFx-15), Trondheim, Norway, Nov 30 - Dec 3, 2015, describes a method to estimate perceived azimuth directions in a stereo signal that can be used to separate direct and ambient signal components and to remix the original stereo track.

While these techniques alleviate some of the shortcomings of basic mid and side signal extraction, such panning-specific extraction techniques are still incapable of separating more general audio sources present in a stereo audio signal, such as moving audio sources, sources with reverberation, or sources which are spatially dominant at various points in time-frequency space.

It is therefore a purpose of this disclosure to provide such an improved method and an audio processing system for performing enhanced audio source separation for stereo audio signals.

SUMMARY OF THE INVENTION

According to a first aspect of the invention there is provided a method for extracting a target mid audio signal from a stereo audio signal, as defined in claim 1.

Obtaining at least one of the target panning parameter and target phase difference parameter may comprise receiving, accessing or determining the target panning parameter and/or target phase difference parameter. At least one of the target panning parameter and/or target phase difference parameter may be replaced with a default value for at least one time segment and frequency band.

With consecutive time segments it is meant segments that describe a time portion of the audio signal wherein later time segments describe later time portions of the audio signal and earlier time segments describe earlier time portions of the audio signal. The consecutive time segments may be overlapping in time or non-overlapping in time.

The representation of a portion of the stereo audio signal may be any time domain representation or any frequency domain representation. The frequency domain representation may be any linear time-frequency domain such as a Short-Time Fourier Transform, STFT, representation or a Quadrature Mirror Filter, QMF, representation.

The invention is at least partially based on the understanding that by obtaining a target panning parameter and/or target phase difference parameter for each time segment and frequency band, a target mid audio signal may be extracted which at all times targets a time and/or frequency variant audio source in the stereo audio signal. Moreover, the method allows extraction of a target mid audio signal targeting two or more audio sources simultaneously which in the stereo audio signal are separated in frequency, as the target mid audio signal is created using individual target panning parameters for each time segment and frequency band.

In some implementations, the weight of the left and right audio signals is based on the target panning parameter such that the left or right audio signal with a greater magnitude is provided with a greater weight.

That is, the left or right audio signal which is associated with a greater magnitude or power (which is indicated by the target panning parameter) will be provided with a greater weight and contribute more to the formation of the target mid audio signal.

In some implementations, the method further comprises extracting, for each time segment and frequency band, a partial side signal representation, wherein the partial side signal representation is based on a weighted difference between the left and right audio signals, wherein a weight of each of the left and right audio signals is based on at least one of the target panning parameter and the target phase difference parameter of each frequency band and time segment and forming a target side audio signal by combining each partial side signal representation for each frequency band and time segment.

In other words, a target side audio signal may be formed in parallel with the target mid audio signal and the target mid and side audio signals form a complete representation of the stereo audio signal. It is understood that any implementation relating to the formation or processing of the target mid audio signal may be performed analogously with the forming and processing of the target side audio signal as will be described in the below.

If the stereo audio signal comprises e.g. an ideal center panned audio source, or a single audio source panned under the constant power law, the target mid audio signal will ideally capture all signal energy of the audio source and the target side audio signal will capture no such energy. For a general audio source(s) however, the target mid audio signal will capture the target audio source(s) and, likely, some other non-target sounds while the target side audio signal will capture non-target sounds while likely eliminating, or nearly eliminating, the target source(s). Inclusion of a target side audio signal in addition to the target mid audio signal ensures that all audio signals of the left and right audio signal pair are present in the target mid and side audio signal pair. For instance, this allows for lossless reconstruction of the left and right audio signals.

Any functions described in relation to a method may have corresponding features in a system or device and vice versa.

BRIEF DESCRIPTION OF THE DRAWINGS

The present invention will be described in more detail with reference to the appended drawings, showing currently preferred embodiments of the invention.

Figure 1 is a block diagram depicting an analysis arrangement according to some implementations.
Figure 2 is a flow chart illustrating a method according to one implementation.
Figure 3 is a block diagram depicting an alternative analysis arrangement according to some implementations.
Figure 4a illustrates a set of target panning parameters and target phase difference parameters distributed over a plurality of time segments and frequency bands according to some implementations.
Figure 4b illustrates a set of partial mid signal representations forming a target mid audio signal according to some implementations.
Figure 4c illustrates a set of partial side signal representations forming a target side audio signal according to some implementations.
Figure 5a is a block diagram of an analysis arrangement according to some implementations.
Figure 5b is a block diagram of an analysis arrangement using alternative panning and phase difference parameters according to some implementations.
Figure 6a is a block diagram of an audio processing system with a mono source separator and a mid/side processor according to some implementations.

Figure 6b is a block diagram of another audio processing system with a stereo processor operating on alternative left and right audio signals according to some implementations.

Figure 6c is a block diagram of yet another audio processing system which applies an estimated stereo softmask to the target mid audio signal reconstructs processed left and right audio signals according to some implementations.

DETAILED DESCRIPTION OF CURRENTLY PREFERRED EMBODIMENTS

Systems and methods disclosed in the present application may be implemented as software, firmware, hardware, or a combination thereof. In a hardware implementation, the division of tasks does not necessarily correspond to the division into physical units; to the contrary, one physical component may have multiple functionalities, and one task may be carried out by several physical components in cooperation.

The computer hardware may for example be a server computer, a client computer, a personal computer (PC), a tablet PC, a set-top box (STB), a personal digital assistant (PDA), a cellular telephone, a smartphone, a web appliance, a network router, switch or bridge, or any machine capable of executing instructions (sequential or otherwise) that specify actions to be taken by that computer hardware. Further, the present disclosure shall relate to any collection of computer hardware that individually or jointly execute instructions to perform any one or more of the concepts discussed herein.

Certain or all components may be implemented by one or more processors that accept computer-readable (also called machine-readable) code containing a set of instructions that when executed by one or more of the processors carry out at least one of the methods described herein. Any processor capable of executing a set of instructions (sequential or otherwise) that specify actions to be taken are included. Thus, one example is a typical processing system (i.e. a computer hardware) that includes one or more processors. Each processor may include one or more of a CPU, a graphics processing unit, and a programmable DSP unit. The processing system further may include a memory subsystem including a hard drive, SSD, RAM and/or ROM. A bus subsystem may be included for communicating between the components. The software may reside in the memory subsystem and/or within the processor during execution thereof by the computer system.

The one or more processors may operate as a standalone device or may be connected, e.g., networked to other processor(s). Such a network may be built on various different network protocols, and may be the Internet, a Wide Area Network (WAN), a Local Area Network (LAN), or any combination thereof.

The software may be distributed on computer readable media, which may comprise computer storage media (or non-transitory media) and communication media (or transitory media). As is well known to a person skilled in the art, the term computer storage media includes both volatile and non-volatile, removable and non-removable media implemented in any method or technology for storage of information such as computer readable instructions, data structures, program modules or other data. Computer storage media includes, but is not limited to, physical (non-transitory) storage media in various forms, such as EEPROM, flash memory or other memory technology, CD-ROM, digital versatile disks (DVD) or other optical disk storage, magnetic cassettes, magnetic tape, magnetic disk storage or other magnetic storage devices, or any other medium which can be used to store the desired information, and which can be accessed by a computer. Further, it is well known to the skilled person that communication media (transitory) typically embodies computer readable instructions, data structures, program modules or other data in a modulated data signal such as a carrier wave or other transport mechanism and includes any information delivery media.

A detailed description of currently preferred embodiments is included in the below together with an introductory section of extraction of basic mid and side audio signals.

**Extraction of basic mid and side audio signals**

Stereo audio signals comprising a left L and a right R audio signal are alternatively represented as a mid audio signal M and a side audio signal S. Basic mid and side audio signals M, S are constructed from the left and right audio signals L, R using the analysis equations

$$M = 0.5L + 0.5R \hspace{4cm} \text{Eq. 1}$$

$$S = 0.5L - 0.5R \hspace{4cm} \text{Eq. 2}$$

and the original left and right audio signals L, R may be reconstructed from the mid and side audio signals M, S using the following synthesis equations

$$L = M + S \qquad \text{Eq. 3}$$

$$R = M - S. \qquad \text{Eq. 4}$$

The mid audio signal M boosts audio signal features that are in-phase and centered in the stereo mix whereas the side audio signal S attenuates in-phase audio signal features. For instance, if the stereo audio signal contains a center-panned left and right audio signal pair L, R (equal magnitude, in-phase components in each of the left and right audio signals), the mid audio signal M will contain the stereo audio signal while the side audio signal S will eliminate it; a basic mid/side audio signal targets a center-panned audio signal for inclusion in the mid audio signal M and for exclusion in the side audio signal S.

**Stereo signals in time domain and time-frequency domain**

The left, right, mid and side audio signals L, R, M, S may be represented in the time domain or frequency domain. The frequency domain representation may for example be a Short-Time Fourier Transform, STFT, representation or a Quadrature Modulated Filter, QMF representation. For example, the left and right audio signals L, R can be represented in the frequency domain as

$$L = |L|e^{i\angle L} \qquad \text{Eq. 5}$$

$$R = |R|e^{i\angle R} \qquad \text{Eq. 6}$$

wherein |L| and |R| denotes the signal magnitude for the left and right audio signals L, R respectively, and wherein $\angle$L and $\angle$R denotes the phase of the left and right audio signals L, R respectively. In general |L|, |R|, $\angle$L and $\angle$R are all functions of frequency, $\omega$, and time, $t$, however the time and frequency dependence $\omega$, $t$ will be excluded from all equations for compactness. There are, therefore, many values represented by each of the symbols |L|, |R|, $\angle$L and $\angle$R. Each such value corresponds to the audio content of the left or right signals, and does not necessarily characterize a single target source. The values may generally be described as "detected" because they are considered to be detected from a stereo input signal in many contexts.

The left and right audio signals L. R may alternatively be represented with a combination of a detected magnitude parameter U and detected panning parameter $\theta$ as

$$U = \sqrt{|L|^2 + |R|^2} \qquad \text{Eq. 7}$$

$$\theta = \arctan\left(\frac{|R|}{|L|}\right) \qquad \text{Eq. 8}$$

meaning that the left and right audio signals L, R from equations 5 and 6 may be represented in terms of $U$, $\theta$ instead of in terms of |L|, |R|. For instance, the left and right audio signals L, R may be expressed as

$$L = U\cos(\theta)\, e^{i\angle L} \qquad \text{Eq. 9}$$

$$R = U\sin(\theta)\, e^{i\angle R}. \qquad \text{Eq. 10}$$

The detected magnitude parameter U and detected panning parameter $\theta$ forms a representation of the stereo audio signal which is referred to as a Stereo-Polar Magnitude (SPM) representation. While the SPM representation may be replaced with any equivalent representation, the SPM representation of the stereo audio signal will be utilized in the following description.

The detected panning parameter $\theta$ ranges from 0 to $\frac{\pi}{2}$ wherein 0 indicates a stereo audio signal in which only the left audio signal L is non-zero and $\frac{\pi}{2}$ indicates a stereo audio signal in which only the right audio signal R is non-zero. A detected panning parameter value of $\theta = \frac{\pi}{4}$ indicates a centered stereo audio signal with equal magnitudes for the left and right audio signals L, R. While the detected panning parameter is derived from a stereo input signal, it also agrees mathematically with a model for source mixing. For an audio source $S_x$ with magnitude $|S_x|$, phase $\psi_x$, and a known panning parameter $\Theta_x$, the left and right audio signals L, R may be expressed as

$$L = |S_x| \cos(\Theta_x)e^{i\psi_x} \qquad \text{Eq. 11}$$

$$R = |S_x| \sin(\Theta_x)e^{i\psi_x}. \qquad \text{Eq. 12}$$

It can be shown that the detected panning parameter $\theta$ for time-frequency points in a signal created with equation 11 and 12 will equal $\Theta_x$ of the audio source $S_x$, as:

$$\theta = \arctan\left(\frac{|R|}{|L|}\right) = \arctan\left(\frac{||S_x|\sin(\Theta_x)|}{||S_x|\cos(\Theta_x)|}\right) = \Theta_x. \qquad \text{Eq. 13}$$

### Mid and side audio signals with fixed panning

The basic mid and side audio signals M, S are extracted by weighting each of the left and right audio signals L, R equally to target an audio source assumed to exist in equal proportions in the left and right audio signals L, R (a centered audio source). For non-centered audio sources, the weighting of the left and right audio signals L, R in equations 1 and 2 should be adjusted.

For instance, the coefficients of the left and right audio signals L, R in equation 1 and 2 may be changed from 0.5 under the constraint that the sum of the coefficients should equal 1. This enables the coefficients for the left and right audio signals L, R in equation 1 to be e.g. 0.7 and 0.3 (and equivalently for the side signal construction in equation 2) for an audio source which appears mainly in the left audio signal. However, this leads to an undesirable situation wherein the magnitude of the mid and side audio signals M, S varies considerably when the audio source moves between the left and right audio signals L, R (assuming constant power law mixing).

To circumvent this issue the mid and side audio signals M, S may be extracted from the left and right audio signals L, R in accordance with

$$M = \cos(\Theta_x)L + \sin(\Theta_x)R \qquad \text{Eq. 14}$$

$$S = \sin(\Theta_x)L - \cos(\Theta_x)R \qquad \text{Eq. 15}$$

for an audio source $S_x$ with a known or estimated "target" panning parameter $\Theta_x$ wherein the left and right audio signals L, R can be reconstructed as

$$L = \cos(\Theta_x)M + \sin(\Theta_x)S \qquad \text{Eq. 16}$$

$$R = \sin(\Theta_x)M - \cos(\Theta_x)S. \qquad \text{Eq. 17}$$

For example, if $\Theta_x = 0$, indicating an audio source appearing only in the left audio signal, the mid audio signal M becomes equal to the left audio signal L and the side audio signal S is equal to the right audio signal R, and vice versa for a $\Theta_x = \frac{\pi}{2}$. Similarly, a mid audio signal M for an audio source appearing with equal magnitudes in the left and right audio signals L, R (i.e. $\Theta_x = \frac{\pi}{4}$) weights the left and right audio signals L, R equally. Furthermore, an audio source located center to left and center to right will result in a weighting of the left and right audio signals L, R with $\Theta_x$ in the range of 0 to $\frac{\pi}{4}$ and $\frac{\pi}{4}$ to $\frac{\pi}{2}$ respectively. The coefficients used to weight the left and right audio signals L, R to construct the mid and side audio signals M, S and vice versa are thus based on a fixed target panning parameter $\Theta_x$.

Extraction of **target mid and** side **audio signals**

An aspect of the present invention relates to creation of a target mid and/or side audio signal M, S based on at least one of a target panning parameter $\Theta$ and a target phase difference parameter $\Phi$ obtained for each time segment and frequency band of a stereo audio signal. The target panning parameter $\Theta$ represents an estimate or indication of the magnitude ratio between the left and right audio signals L, R in each time segment and frequency band, for sounds corresponding to the target source or sources. The target phase difference parameter $\Phi$ represents an estimate or indication of the phase difference between the left and right audio signals L, R in each time segment and frequency band, for sounds corresponding to the target source or sources.

According to the invention, the panning parameter $\Theta$ and/or phase difference parameter $\Phi$ of each time segment and frequency band 111, 112 is the median, mean, mode, numbered percentile, maximum or minimum panning parameter $\Theta$ and/or phase difference parameter $\Phi$ of the time segment. In general, the detected panning parameter $\theta$ and/or detected phase difference parameter $\phi$ exists for each sample of the stereo audio signal. However, the target panning parameter $\Theta$ and/or phase difference parameter $\Phi$ used to create the target mid and side audio signals M, S are not of such fine granularity and represent a statistical feature (e.g. the average) of multiple samples, such as an average of all samples within a predetermined time segment. For example, whereas the detected panning parameter $\theta$ and/or detected phase difference parameter $\phi$ may assume different values more than one thousand times per second the target panning parameter $\Theta$ and/or phase difference parameter $\Phi$ only change a few times per second.

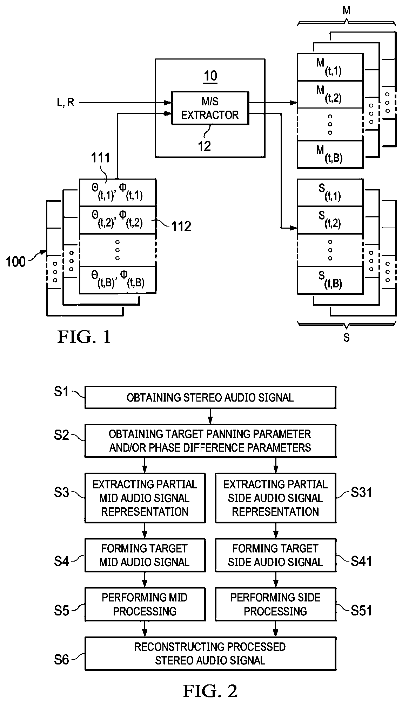

Fig. 1 illustrates an analysis arrangement 10 extracting a target mid M and target side S audio signal from a stereo signal comprising a left and right audio signals L, R. The extraction of the mid and side audio signals M, S is performed in the extraction unit 12 of the analysis arrangement 10 which obtains the left and right audio signals L, R together with a target panning parameter $\Theta$ and/or target phase difference parameter $\Phi$ for a plurality of time segments 100 and frequency of bands 111, 112.

The extraction unit 12 obtains the left and right audio signals L, R (stereo audio signal) as a plurality of consecutive time segments, each time segment comprising a representation of a portion of the left and right audio signals R, L. Alternatively, the extraction unit 12 is configured to divide the left and right audio signals R, L into the plurality of consecutive time segments. Each time segment comprises two or more frequency bands of the stereo audio signal wherein each frequency band in each time segment is associated with at least one of an obtained target panning parameter $\Theta$ and an obtained target phase difference parameter $\Phi$.

In the embodiment shown in fig. 1 the analysis arrangement 10 receives the left and right audio signals L, R and a target panning parameter $\Theta$ and/or target phase difference parameter $\Phi$ for each frequency band 111, 112 of each time segment wherein the number of frequency bands ranges from band 1 to band B. $\Theta_{(t,1)}$ and $\Phi_{(t,1)}$ represents the target panning parameter $\Theta$ and target phase difference parameter $\Phi$ for a first frequency band 111 of time segment t while $\Theta_{(t,2)}$ and $\Phi_{(t,2)}$ represents the target panning parameter and target phase difference parameter for a second frequency band 112 of the time segment t.

With the left and right audio signals L, R and a target panning parameter $\Theta$ and/or target phase difference parameter $\Phi$ the extraction unit 12 extracts the target mid audio signal M and the target side audio signal S. In some implementations, the extraction unit 12 extracts only one of the target mid M and side S audio signal, such as only the mid audio signal M.

To allow modeling of the interchannel phase difference between the left and right audio signals L, R the genuine source phase of a target audio source is defined as being proportionally closer to the left or right audio signal which exhibits the greater magnitude. That is, for a stereo audio signal which is dominated in power or magnitude by the left audio signal L the phase of left audio signal L will be closer to the genuine source phase of the audio source compared to the phase of the right audio signal R, and vice versa for a stereo audio signal dominated by the right audio signal R. An audio source $S_x$ is modeled to appear in the left and right audio signals L, R according to the following mixing equations

$$L = |S_x| \cos(\Theta_x) e^{i(\psi_x + \Phi_x \sin^2 \Theta_x)} \qquad \text{Eq. 18}$$

$$R = |S_x| \sin(\Theta_x) e^{i(\psi_x - \Phi_x \cos^2 \Theta_x)} \qquad \text{Eq. 19}$$

wherein $\psi_x$ is the phase of the audio source $S_x$ and $\Phi_X$ is the phase difference parameter for the target source.

Based on the mixing model described in equations 17 and 18 above, the extraction device 12 may employ the following analysis equations to target a source with target panning parameter $\Theta$ and target phase difference parameter $\Phi$.

$$M = \cos(\Theta) e^{i(-\Phi \sin^2 \Theta)} L + \sin(\Theta) e^{i(\Phi \cos^2 \Theta)} R \qquad \text{Eq. 20}$$

$$S \;=\; \sin(\Theta)e^{i(-\Phi\sin^2\Theta)}\,L \,-\, \cos(\Theta)e^{i(\Phi\cos^2\Theta)}\,R \qquad \text{Eq. 21}$$

It is understood that $\Theta$ and $\Phi$ can vary with time and frequency, corresponding with the characteristics of a targeted source. The mid and side signals of equations 20 and 21 may be termed "target mid and side signals." Therefore M and S may be understood as signals comprised of separate signal components corresponding to the various values of $\Theta$ and $\Phi$ for each time segment and frequency band 111, 112. The weighting of the phase difference parameter $\Phi$ for the left and right audio signals L, R with $\sin^2\Theta$ and $\cos^2\Theta$ is merely exemplary and other weighting functions based on $\Theta$ are possible. For instance, $\sin^2\Theta_x$ may be replaced with $\dfrac{2}{\pi\Theta}$ and $\cos^2\Theta$ may be replaced with $1 - \dfrac{2}{\pi\Theta}$. Similarly, the model of equations 18 and 19 which uses weighting of the phase difference parameter $\Phi$ for the left and right audio signals L, R with $\sin^2\Theta_x$ and $\cos^2\Theta_x$ is also merely exemplary.

In equation 20 the target mid audio signal M is based on a weighted sum of the left and right audio signals L, R wherein the weight of the left audio signal is $\cos(\Theta)e^{i(-\Phi\sin^2\Theta)}$ and the weight of the right audio signal is $\sin(\Theta)e^{i(\Phi\cos^2\Theta)}$ and wherein the panning and/or phase difference parameter $\Theta$, $\Phi$ is obtained for each time segment and frequency band 111, 112.

Similarly, in equation 20 the target side audio signal S is based on weighted difference between the left and right audio signals L, R wherein the weight of the left audio signal is $\sin(\Theta)e^{i(-\Phi\sin^2\Theta)}$ and the weight of the right audio signal is $\cos(\Theta)e^{i(\Phi\cos^2\Theta)}$ and wherein the panning and/or phase difference parameter $\Theta$, $\Phi$ is obtained for each time segment and frequency band 111, 112.

The weights of the left and right audio signals L, R in the weighted sum and weighted difference of equations 20 and 21 used to extract the mid and side audio signals M, S are complex valued and comprises a real valued magnitude factor, e.g. $\cos(\Theta)$, and an complex valued phase factor, e.g. $e^{i(-\Phi\sin^2\Theta)}$. The obtained target panning and/or target phase difference parameters $\Theta$, $\Phi$ will influence the weights to enable extraction of the target mid and/or side audio signal M, S.

For instance, the real valued magnitude factor may be based on $\Theta$ such that the left or right audio signal with a greater magnitude is provided with a greater weight in the weighted sum. Moreover, the complex valued factor may be based on $\Phi$ such that a greater phase difference $\Phi$ means that there is a greater difference between the respective phases of the weights in the weighted sum. In some implementations, the complex valued factor of each weight in the weighted sum is based on both $\Phi$ and $\Theta$, e.g. one of the weights is $e^{i(-\Phi\sin^2\Theta)}$, such that the weight of the left or right audio signal L, R with a greater magnitude is provided with a smaller phase.

Analogously, the real valued magnitude factor in the weighted difference (for the target side signal extraction) may be based on the target panning parameter $\Theta$ such that the left or right audio signal with a greater magnitude is provided with a smaller weight in the weighted difference. Moreover, the complex valued factor may be based on $\Phi$ such that a greater phase difference $\Phi$ means that there is a greater difference between the respective phases of the weights in the weighted difference. In some implementations, the complex valued factor of each weight in the weighted difference is based on both $\Phi$ and $\Theta$, e.g. one of the weights is $\sin(\Theta)e^{i(-\Phi\sin^2\Theta)}$, such that the weight of the left or right audio signal with a greater magnitude is provided with a smaller phase.

In some implementations, only one of the target panning and phase difference parameter $\Theta$, $\Phi$ is obtained for at least one time segment and frequency band 111, 112 wherein the other one is assigned a default value. For instance, if only the target panning parameter $\Theta$ is obtained the target phase difference parameter $\Phi$ is assumed to be $\Phi = 0$ and if only the target phase difference parameter $\Phi$ is obtained the target panning parameter $\Theta$ is assumed to be $\Theta = \dfrac{\pi}{4}$. These default values assume an audio source centered in the stereo audio signal with no interchannel phase difference, however other default values are possible.

The extraction device 12 obtains the target mid audio signal M by combining partial mid signal components or representations $M_{(t, n)}$ of each frequency band in each time segment. Similarly, extraction device 12 obtains the target side audio signal S by combining partial side signal representations $S_{(t, n)}$ of each frequency band in each time segment. A partial mid signal component or representation $M_{(t, n)}$ is created for each frequency band 1...B of a time segment t and by combining all the partial mid signal representations $M_{(t, n)}$ for time segment, t, a target mid audio signal time segment M(t) is created wherein a sequence of target mid audio signal time segments M(t) forms the target mid audio signal M. The target side audio signal S is formed in an analogous manner. Combining the partial mid signal representations $M_{(t, n)}$ for frequency bands 1...B may comprise processing the partial target mid audio signals $M_{(t, n)}$ with a synthesis filterbank.

With further reference to the flow chart in fig. 2 the method performed by the analysis arrangement 10 is described in detail. The stereo audio signal is obtained by the analysis arrangement 10 at S1 and the target panning and/or phase difference parameter $\Theta$, $\Phi$ is obtained by the analysis arrangement 10 for a plurality of time segments 100 and frequency bands 111, 112 at step S2.

At step S3 a partial mid signal representation $M_{(t, n)}$ is extracted by the mid/side extractor 12 (e.g. in accordance with equation 19 in the above) wherein the partial mid signal representation is based on a weighted sum of the left and right audio signals L, R. The weight of each of the left and right audio signals L, R is based on at least one of the target panning parameter $\Theta$ and the target phase difference parameter $\Phi$ of each frequency band 111, 112 and time segment. Analogously, a partial side signal representation $S_{(t, n)}$ is extracted at step S31 (e.g. in accordance with equation 20 in the above) wherein the partial side signal representation is based on a weighted difference of the left and right audio signals L, R.

In some implementations, the target side audio signal S is not computed and the extractor unit 12 is e.g. an extractor unit 12 configured to extract exclusively the target mid audio signal M. Alternatively, the target side audio signal S is computed but scaled down at step S51 by a small value, or zero, prior to reconstruction of the left and right audio signals L, R at step S6 (e.g. using the reconstruction equations 21 and 22 in the below). As the target mid audio signal M in some cases is expected to capture substantially all energy of the target audio source the target side audio signal S may comprise mainly undesirable noise or background audio which can be omitted or attenuated.

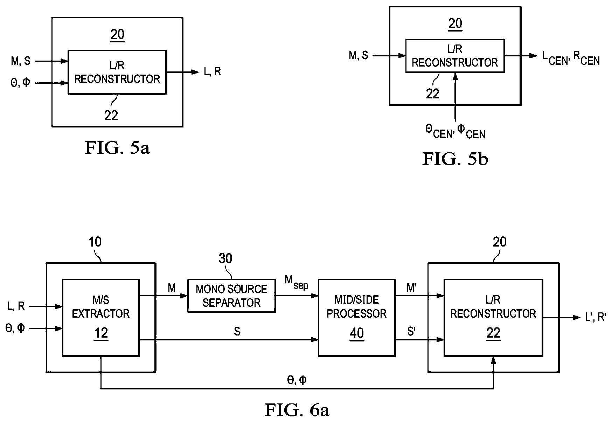

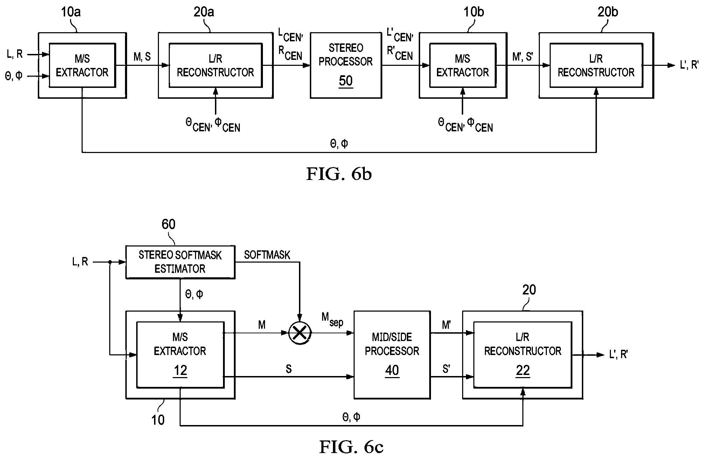

Following step S3 and step S31 the method goes to step S4 and S41 comprising forming target mid and side audio signals M, S by combining the partial mid and side signal representations $M_{(t, n)}$, $S_{(t, n)}$ into target mid and side audio signals M, S respectively. The method continues with step S5 and S51 comprising performing processing of the target mid and/or side audio signal M, S and examples of processing involves attenuating the target side audio signal S or providing the target mid audio signal M to a mono source separator as will be described in connection to fig. 6a, 6b and 6c in the below.

Lastly, the method goes to step S6 comprising reconstructing the left and right audio signals L, R from the target mid and side audio signals M, S. The reconstruction of the left and right audio signals L, R from the target mid and side audio signals M, S is performed by a synthesis arrangement as will be described more in detail in connection to fig. 5a and 5b in the below.

As an example of the operation of the analysis arrangement 10, an audio source of the left and right audio signals L, R with time varying panning is considered. The audio source is panned, under the constant power law, at a constant rate from fully right to fully left as time $t$ advances from 0 to 10 seconds. For basic mid and side audio signals extracted for this audio source, e.g. in accordance with equation 1 and 2 in the above, the mid audio signal M will capture substantially all energy of the audio source at $t = 5$ and substantially no energy at $t = 0$ and $t = 10$ whereas the side audio signal S will capture substantially all the energy of the audio source at $t = 0$ and $t = 10$ and substantially no energy at $t = 5$. The target mid audio signal M, extracted with varying panning parameters and/or phase difference parameters $\Theta$, $\Phi$ for each time segment and frequency band will contain substantially all of the audio source energy for any $t \in [0, 10]$ whereas the target side audio signal S will contain substantially no energy of the of the time varying audio source.

The constant power law ensures that the audio signal power (which is proportional to the sum of the square of the amplitudes) of the left and right audio signals L, R remains constant for all panning angles. For instance, the audio signal amplitudes of the left and right audio signal are scaled with a scaling factor which depends on the panning angle to ensure that the square of the sum of the left and right audio signal is equal for all panning angles. Different from the linear panning law, which ensures that the sum of the signal amplitudes is constant which allows the total signal power to vary with the panning angle, the constant power panning law will ensure that the perceived audio signal power is constant for all panning angles. The constant power law is e.g. described in "Loudness Concepts & Pan Laws" by Anders Øland and Roger Dannenberg, Introduction to Computer Music, Carnegie Mellon University.

This demonstrates how the target mid and side audio signals M, S is capable of targeting and separating audio source(s) that are varying in time and frequency in a stereo audio signal. Additionally, if a second audio source of a separate frequency is moved between left and right audio signals L, R at a rate different from the first audio source (or is stationary e.g. at a center panning), the target mid audio signal M targets the first and second audio source in individual frequency bands meaning that substantially all energy from both audio sources will be present in the target mid audio signal M despite the audio sources being of different frequency while also being shifted between the left and right audio signals L, R at different rates.

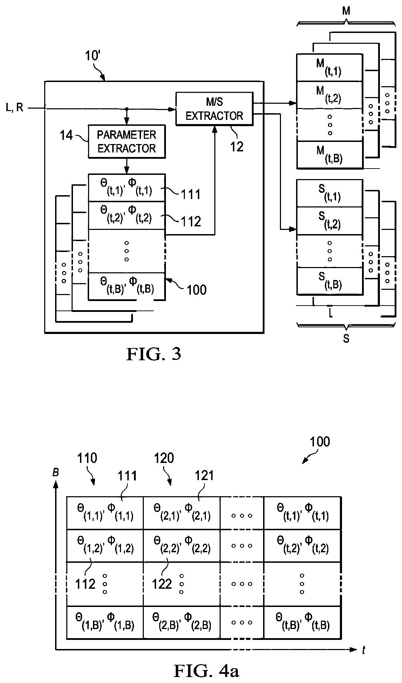

In fig. 3 a combined analysis arrangement 10' is depicted that is configured to extract a target mid and side audio signals M, S in accordance with the above while also extracting or determining the target panning parameter $\Theta$ and/or phase difference parameter $\Phi$ for each frequency band 111, 112 and time segment of the left and right audio signals L, R using a parameter extractor unit 14. Accordingly, the target panning parameter $\Theta$ and/or phase difference parameter $\Phi$ are obtained alongside the left and right audio signals L, R or determined from the left and right audio signals L, R. An example method of doing so will now be described.

The target phase difference parameter $\Phi$ may be calculated, e.g. by the parameter extractor 14, as the typical or dominant phase difference between the left and right audio signals L, R in each time segment and frequency band 111, 112. For instance, in the time-frequency domain (e.g. in the STFT domain), detected phase differences may be calculated for each STFT tile as $\phi = \mathrm{Arg}(R/L)$, and by analyzing the distribution on $\phi$, a value of $\Phi$ may be estimated to be a dominant or typical value for the time segment and frequency band. Similarly, detected panning parameters $\theta$ may be calculated as $\theta = \arctan(|R|/|L|)$ for each STFT tile, and by analyzing the distribution thereupon, a values of $\Theta$ may be estimated to be a dominant or typical value for the time segment and frequency band, wherein L and R represent the left and right audio signals L, R in the time segment and frequency band 111, 112. Typical or dominant values estimated from a distribution may be the median, mean, mode, numbered percentile, minimum or maximum values.

In "Dialog Enhancement via Spatio-Level Filtering and Classification" (Convention Paper 10427 of the 149th Convention of the Audio Engineering Society by Master, A et al.) a method for obtaining indicators of the average value and spread of the panning and interchannel phase difference labelled thetaMid, thetaWidth, phiMid and phiWidth is proposed. The panning parameter $\Theta$ used by the analysis arrangement 10 could be based on the thetaMiddle proposed in this convention paper and, similarly, the target phase difference parameter $\Phi$ used by the analysis arrangement 10 could be based on phiMiddle of the so called "Shift and Squeeze" or "S&S" parameters proposed in this paper.

For each time segment and frequency band within it, the audio processing system may create a 51-bin histogram on $\theta$ weighted by the magnitude U squared, i.e. $U^2$. The system does the same for the detected panning parameter $\phi$, as well as a version of $\phi$ ranging from 0 to 2*pi, which is called $\phi2$. However, these histograms each use 102 bins. The histograms are each smoothed over their given dimensions and vs time segments. For the smoothed $\theta$ histograms, the system detects the target panning parameter as the highest peak, which is called thetaMiddle, and also the width around this peak necessary to capture 40% of energy in the histogram, which is called thetaWidth. It does the same for $\phi$ and $\phi2$, recording phiMiddle, phi2Middle, phiWidth and phi2Width, but requiring 80% energy capture for widths. The system records final values for phiMiddle and phiWidth based on which had a higher concentration in phi space as indicated by a smaller phiWidth value

For instance, the parameter extractor 14 in fig. 3 creates, for each time segment and frequency band within it, a histogram of the detected panning parameter $\theta$ weighted with the total signal power $U^2$ from equation 7 and does the same for the detected phase difference parameter $\phi$. The histograms may have an arbitrary number of bins such as ten or more bins, or 50 or more bins. In one implementation, each histogram has 51 bins. The histograms are each smoothed with a suitable smoothing function with respect to at least the time dimension and/or with respect to the time and $\theta$ or $\phi$ dimension. For the smoothed $\theta$ histograms, the system detects the $\theta$ value of the highest peak, which is called thetaMiddle, and also the width around this peak necessary to capture 40% of energy in the histogram, which is called thetaWidth. The same is done for $\phi$, recording phiMiddle and phiWidth, but requiring 80% energy capture for widths. It is understood that the parameter extractor 14 may be configured to either obtain the detected the detected panning parameter $\theta$ and/or detected phase difference parameter $\phi$ and/or detected magnitude U or determine the detected panning parameter $\theta$ and/or detected phase difference parameter $\phi$ and/or detected magnitude U (using e.g. equation 7) from the left and right audio signal L, R.

Details of time **segments and frequency bands**

With reference to fig. 4a a plurality of time segments 110, 120 ranging from a first time segment to time segment *t* are depicted wherein each time segment 110, 120 comprises a plurality of frequency bands 111, 112, 121, 122 ranging from a first frequency band to frequency band *B*. The time segments 110, 120 and frequency bands 111, 112, 121, 122 forms a time and frequency tile representation wherein each frequency band of each time segment forms a respective time/-frequency tile.

As indicated in fig. 4a, each frequency band 111, 112, 121, 122 of each time segment 110, 120 is associated with a respective target panning parameter $\Theta$ and/or target phase difference parameter $\Phi$. At least two frequency bands 111, 112, 121, 122 (or subbands) are defined for each time segment 110, 120, such as a high frequency band and a low frequency band comprising frequencies above and below a threshold frequency. That is, each time segment 110, 120 comprises frequency bands 1 ... B wherein B is at least two. Experiments have shown that octave or quasi-octave frequency bands are well suited for targeting of dialogue audio sources such as frequency bands with edges at 0 Hz, 400 Hz, 800 Hz, 1600 Hz, 3200 Hz, 6400 Hz, 13200 Hz and 24000 Hz, although different band distributions are possible.

The duration of each time segment may correspond to 10 ms to 1 s of the stereo audio signal. In some implementations each time segment corresponds to a plurality of frames of the stereo audio signal, such as 10 frames, wherein each frame e.g. represents 10 to 200 ms of the stereo audio signal, such as 50 to 100 ms of the stereo audio signal. Experiments have shown that using 10 overlapping frames to represent one time segment, wherein each frame is 50 to 100 ms long with 75 % overlap, is a good trade-off between rapid response, parameter stability, parameter reliability and computational expense for typical dialog sources. However, time segments of longer or shorter duration are also considered, specifically for audio sources other than dialog, such as music.

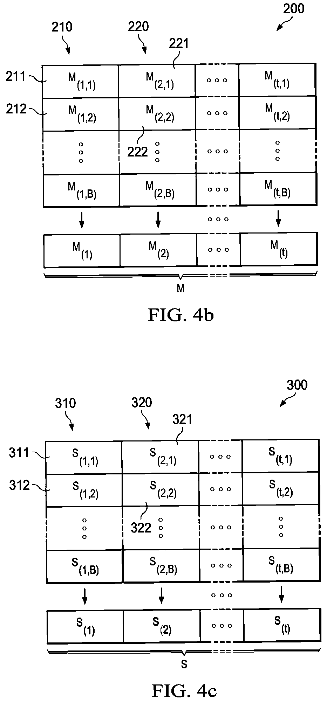

Fig. 4b illustrates partial mid audio signal representations $M_{(t, b)}$ extracted for each time segment 210, 220 and frequency band 211, 212, 221, 222. As seen, a first time segment 210 comprises a partial mid audio signal representation $M_{(1,1)}$ for the first frequency band 211, a second partial mid audio signal representation $M_{(1,1)}$ for the second frequency band 212 and so forth until the last mid audio signal representation $M_{(1,B)}$ of frequency band B. By combining the partial mid audio signal representations $M_{(1,1)}$ ... $M_{(1,B)}$ of the first time segment 210 a first time segment $M_{(1)}$ of the target mid audio signal M is created. Similarly, subsequent time segments $M_{(2)}...M_{(t)}$ of the target mid audio signal M are created by combining the partial mid audio signal representations $M_{(1,1)}$ ... $M_{(1,B)}$ of subsequent time segments 220. Finally, the target mid audio signal M is created by combining each time segment $M_{(1)}...M_{(t)}$ in sequence.

With further reference to fig. 4c there is illustrated partial side audio signal representations $S_{(t, b)}$ extracted for each time segment 310, 320 and frequency band 311, 312, 321, 322. The partial side audio signals representations $S_{(t, b)}$ are combined to form the target side audio signal S in a manner analogous to the combination of the partial mid audio signal representations $M_{(t, b)}$ described in the above. It is understood that the extraction and combination of the partial mid audio signal representations $M_{(t, b)}$ and/or partial side audio signal representations $S_{(t, b)}$ may be performed in a single step by a single processing unit or as two or more steps performed by two or more processing units.

Reconstruction of left and **right audio signals from target mid and side audio signals**

Fig. 5a illustrates a block chart illustrating a synthesis arrangement 20 for performing reconstruction of the left and right audio signals L, R from the target mid and side audio signals M, S. The synthesis unit 20 comprises a reconstructor unit 22 which reconstructs the left and right audio signals L, R from a target mid and side audio signals M, S using the panning parameter $\Theta$ and/or phase difference parameter $\Phi$. For instance, the reconstructor unit 22 implements the following synthesis equations

$$L = (\cos(\Theta) M + \sin(\Theta)S)e^{i(\Phi \sin^2 \Theta)} \qquad \text{Eq. 22}$$

$$R = (\sin(\Theta) M - \cos(\Theta)S)e^{i(\Phi \cos^2 \Theta)} \qquad \text{Eq. 23}$$

for the target mid and side audio signals M, S extracted with equations 20 and 21. The target panning parameter $\Theta$ and/or target phase difference parameter $\Phi$ obtained by the synthesis arrangement is here equal to the target panning parameter $\Theta$ and/or phase difference parameter $\Phi$ determined or obtained by the analysis arrangement. Alternatively, the target panning parameter $\Theta$ and/or phase difference parameter $\Phi$ used by the synthesis arrangement are alternative parameters $\Theta_{ALT}$, $\Phi_{ALT}$ and/or at least one of $\Theta$ and $\Phi$ is unspecified and replaced with a default value for at least one time segment and frequency band.

As seen in equation 22 and 23, the reconstruction of the left and right audio signals L, R is based on a weighted sum and weighted difference of the target mid and side audio signals M, S. However, these equations may be modified to downweight or eliminate the contribution from the side signal. For instance, the left and right audio signals L, R may be reconstructed from only the target mid audio signal M with a mid weighting factor of $\cos(\Theta) e^{i(\Phi \sin2 \Theta)}$ for the left signal and a mid weighting factor of $\sin(\Theta) e^{i(\Phi \cos2 \Theta)}$ for the right signal respectively, wherein the weighting factors are based on at least one of the target panning parameter $\Theta$ and target phase difference parameter $\Phi$. In this example, the contribution from the side signal is zero. Other contributions between zero and the values shown in equations 22 and 23 are possible.

Similarly, the left and right audio signals L, R may be reconstructed by taking the target side audio signal S into account. In such cases the left audio signal L is based on a weighted sum of the target mid audio signal M and target side audio signal S wherein the weights, $\cos(\Theta) e^{i(\Phi \sin2 \Theta)}$ and $\sin(\Theta) e^{i(\Phi \sin2 \Theta)}$ are based on at least one of the panning parameter and the phase difference parameter. While the right audio signal R is based on a weighted difference between the target mid audio signal M and the target side audio signal S wherein the weights, $\sin(\Theta) e^{i(\Phi \cos2 \Theta)}$ and $\cos(\Theta) e^{i(\Phi \cos2 \Theta)}$, are based on at least one of the panning parameter $\Theta$ and the phase difference parameter $\Phi$. The contribution from the mid signal may also be downweighted or reduced to zero.

Fig. 5b is a block chart illustrating a synthesis arrangement 20 for performing reconstruction using equations 22 and 23 with an alternative panning parameter $\Theta_{ALT}$ and/or alternative phase difference parameter $\Phi_{ALT}$ which results in alternative left and right audio signals $L_{ALT}$, $R_{ALT}$. In the implementation shown, $\Theta_{ALT} = \Theta_{CEN} = \frac{\pi}{4}$ and $\Phi_{ALT} = \Phi_{CEN} = 0$ for all time segments and frequency bands to create a center-panned stereo audio signal comprising a centered left and right audio signals $L_{CEN}$, $R_{CEN}$ with no inter-channel phase difference.

The alternative mid and side weighing factors may be defined as the mid and side weighting factors described in equation 22 and 23, with $\Theta$, $\Phi$ replaced with the alternative counterparts $\Theta_{ALT}$, $\Phi_{ALT}$ obtained for each time segment and frequency band. In some implementations, the alternative left and right audio signals $L_{ALT}$, $R_{ALT}$ are created using only the target mid audio signal M and the alternative mid weighting factors (being e.g. the coefficients of the target mid audio signal M in equation 22 and 23 with $\Theta_{ALT}$, $\Phi_{ALT}$ replacing $\Theta$, $\Phi$). Alternatively, the alternative left and right audio signals $L_{ALT}$, $R_{ALT}$ are created using both the target mid and target side audio signal M, S and the alternative mid and side weighting factors (being e.g. the coefficients of the target mid audio signal M and target side audio signal S in equation 22 and 23 respectively, with $\Theta_{ALT}$, $\Phi_{ALT}$ replacing $\Theta$, $\Phi$).

**Processing arrangements implementing target mid and side audio signals**

In the following, fig. 6a, 6b and 6c depicts block diagrams illustrating an audio processing system comprising the analysis arrangement 10 and synthesis arrangement 20 in combination with additional audio processing units such as a mono source separator 30, a mid/side processor 40, a stereo processor 50 and a stereo softmask estimator 60 for performing audio processing of the target mid and side audio signals M, S or alternative left and right audio signals $L_{CEN}$, $R_{CEN}$.

Fig. 6a illustrates an audio processing system for processing a stereo audio signal via the target mid and side audio signal M, S extracted by the analysis arrangement 10. As seen, the target mid audio signal M is used as input to a mono source separator 30. Additionally, the target mid and side M, S audio signals are provided to a mid/side processor 40 for applying a boost and/or attenuation to the audio signals.

The target mid audio signal M is provided to a mono source separation system 30 configured to separate an audio source in the target mid audio signal M and produce a source separated mid audio signal $M_{sep}$. For instance, the mono source separation system 30 produces a source separated mid audio signal $M_{sep}$ with enhanced intelligibility of at least one audio source present in the target mid audio signal M.

The source separated mid audio signal $M_{sep}$ is provided together with the target side audio signal S to a mid/side processor 40 to produce processed mid and side audio signals M', S'. The mid/side processor 40 may apply a gain to the source separated mid audio signal $M_{sep}$ and/or attenuate the target side signal S. In some cases, the mid/side processor 40 sets the target side audio signal S to zero. The processed mid and side audio signals M', S' are then provided to a synthesis arrangement 20 comprising a left and right audio signals reconstruction unit 22 which reconstructs a processed left and right audio signals L', R' based on the processed mid and side audio signals M', S' and the panning and/or phase difference parameters $\Theta$, $\Phi$ obtained by the analysis arrangement 10.

In some implementations, the source separated mid audio signal $M_{sep}$ is provided directly to the synthesis arrangement 20 which reconstructs a processed left and right audio signals L', R' based on at least the source separated mid audio signal $M_{sep}$ (and optionally the target side audio signal S) and the target panning and/or phase difference parameters $\Theta$, $\Phi$.

Alternatively, the mono source separation system 30 is omitted and the target mid audio signal M and target side audio signal S is provided directly to the mid and side audio processing unit 40 which extracts processed mid and side audio signals M', S' from the target mid and side audio signals M, S.

Fig. 6b illustrates how the target mid audio signal M and the target side audio signal S are used to extract alternative centered left and right audio signals $L_{CEN}$, $R_{CEN}$ to enable use of a stereo processing system 50 for center panned stereo audio signals.

The analysis arrangement 10a obtains an arbitrary left and right audio signals L, R and the target panning and/or phase difference parameters $\Theta$, $\Phi$ for each time segment and frequency band and extracts a target mid audio signal M and a target side audio signal S. The target mid and side audio signal M, S is provided to the synthesis arrangement 20a which also obtains a set of alternative centered panning and/or phase difference parameters $\Theta_{CEN}$, $\Phi_{CEN}$ indicating center panned stereo audio signal. Accordingly, the analysis arrangement 10a and synthesis arrangement 20a creates a center panned stereo signal comprising a centered left and right audio signals $L_{CEN}$, $R_{CEN}$ from an arbitrary original stereo signal.

The center panned alternative left and right audio signals $L_{CEN}$, $R_{CEN}$ are provided to a stereo processing system 50 configured to perform stereo source separation on center panned stereo sources to output processed centered left and right audio signals L'$_{CEN}$, R'$_{CEN}$. The processed centered left and right audio signals L'$_{CEN}$, R'$_{CEN}$ features e.g. enhanced intelligibility of at least one audio source present in the centered left and right audio signals $L_{CEN}$, $R_{CEN}$.

The processed centered left and right audio signals L'$_{CEN}$, R'$_{CEN}$ are then provided to a second analysis arrangement 10b which extracts a processed mid and side audio signals M', S' using the processed centered left and right audio signals L'$_{CEN}$, R'$_{CEN}$ and the centered panning and/or phase difference parameters $\Theta_{CEN}$, $\Phi_{CEN}$. Lastly, a second synthesis arrangement 20b utilizes the original panning and/or phase difference parameters $\Theta$, $\Phi$ obtained or determined by the first analysis arrangement 10a to reconstruct processed left and right audio signals L', R'.

It is noted that the centered panning and/or phase difference parameters $\Theta_{CEN}$, $\Phi_{CEN}$ indicating center panning with no interchannel phase difference is one alternative of among many possible values of alternative panning and/or phase difference parameters $\Theta_{ALT}$, $\Phi_{ALT}$. For instance, the centered alternative parameters $\Theta_{CEN}$, $\Phi_{CEN}$ may be replaced with arbitrary alternative parameters $\Theta_{ALT}$, $\Phi_{ALT}$ which e.g. indicates a strictly right or left stereo audio signal with or without a non-zero phase difference.

It is further noted that the target mid and side audio signals M, S fed between the first analysis arrangement 10a and first synthesis arrangement 20a may be subject to mono signal separation processing and/or mid and side processing as described in connection to fig. 6a in the above. The same applies to the processed target mid and side audio signals M', S' fed between the second analysis arrangement 10b and the second synthesis arrangement 20b. That is, a mono source separator 30 and/or a mid/side processor 40 from fig. 6a may be used to process the mid and side audio signals passed between at least one of: the first analysis arrangement 10a and first synthesis arrangement 20a and between the second analysis arrangement 10b and the second synthesis arrangement 20b. Additionally, while the first analysis and synthesis arrangements 10a, 20a are depicted as separate units they may be combined into a single unit, with reference to equations 20, 21, 22, 23 it is clear that the operations for creating the alternative left and right audio signals $L_{CEN}$, $R_{CEN}$ may be performed as a single step. The same applies to the second analysis and synthesis arrangements 10b, 20b.

In some implementations, the alternative (e.g. centered) left and right audio signals $L_{CEN}$, $R_{CEN}$ are created by the first synthesis arrangement 20a using only the target mid audio signal M. Analogously, the second analysis arrangement 10b may be configured to extract only the processed target mid audio signal M'.

Fig. 6c illustrates an analysis arrangement 10 operating in conjunction with a filter estimator configured to receive the left and right audio signals L, R and estimate a filter for source separation. The filter estimator is e.g. a stereo softmask estimator 60 configured to receive the left and right audio signals L, R and estimate a softmask F. The stereo softmask estimator 60 may be any softmask estimator and e.g. configured to output a softmask F intended for stereo source separation. Traditionally, the softmask F is applied to the left and right audio signals L, R of a stereo audio signal.

In the implementation shown in fig. 6c, the estimated stereo softmask F is applied to the target mid audio signal M to form a source separated mid audio signal $M_{sep}$. The source separated mid audio signal $M_{sep}$ is provided together with a target side audio signal S to a mid/side processor 40 which outputs a processed target mid audio signal M' and a processed target side audio signal S' wherein the processed side audio signal S' may be downweighted compared with S, including a downweight down to zero. The processed target mid audio signal M' and the processed target side audio signal S' are provided to a synthesis unit 20 which reconstructs processed left and right audio signals L', R'. Optionally, the mid/side processor is omitted whereby the source separated mid audio signal $M_{sep}$, and optionally the target side audio signal S are provided directly to the synthesis unit 20 for reconstruction.

The stereo softmask estimator 60 is configured to determine or obtain the panning and/or phase difference parameter $\Theta$, $\Phi$ and provide these parameters to the analysis arrangement 10. Alternatively, the panning and/or phase difference parameter $\Theta$, $\Phi$ are obtained from elsewhere by the analysis arrangement 10 or determined by the analysis arrangement 10 based on the left and right audio signals L, R.

Unless specifically stated otherwise, as apparent from the following discussions, it is appreciated that throughout the disclosure discussions utilizing terms such as "processing", "computing", "calculating", "determining", "analyzing" or the like, refer to the action and/or processes of a computer hardware or computing system, or similar electronic computing devices, that manipulate and/or transform data represented as physical, such as electronic, quantities into other data similarly represented as physical quantities.

It should be appreciated that in the above description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Note that when the method includes several elements, e.g., several steps, no ordering of such elements is implied, unless specifically stated. Furthermore, an element described herein of an apparatus embodiment is an example of a means for carrying out the function performed by the element for the purpose of carrying out the invention. In the description provided herein, numerous specific details are set forth. However, it is understood that embodiments of the invention may be practiced without these specific details. In other instances, well-known methods, structures and techniques have not been shown in detail in order not to obscure an understanding of this description. The person skilled in the art realizes that the present invention by no means is limited to the preferred embodiments described above. On the contrary, many modifications and variations are possible within the scope of the appended claims. For example, the stereo processing system in fig. 6c may further comprise a mono source separator 30 operating on the mid audio signal M or the source separated mid audio signal $M_{sep}$. As a further example it is envisaged that all components or processes relating to forming a target mid and side audio signal and processing a mid and side audio signal may be configured to form or process only the target mid audio signal or, alternatively, the target mid audio signal and the target side audio signal. Similarly, reconstructing a left and right audio signal (e.g. an alternative or centered left and right audio signal) based on the target mid and side audio signals may comprise reconstructing a left and right audio signal using only the target mid audio signal or, alternatively, using both the target mid and side audio signal.

## Claims

1. A computer-implemented method for extracting a target mid audio signal (M) from a stereo audio signal, the stereo audio signal comprising a left audio signal (L) and a right audio signal (R), said method comprising:

obtaining (S1) a plurality of consecutive time segments of the stereo audio signal, wherein each time segment comprises a representation of a portion of the stereo audio signal;

obtaining (S2), for each frequency band of a plurality of frequency bands of each time segment of the stereo audio signal, at least one of:

a target panning parameter ($\Theta$), representing a distribution over the time segment of a magnitude ratio between the left and right audio signals (L, R) in the frequency band, wherein the target panning parameter ($\Theta$) represents a statistical feature of multiple samples within the time segment, the statistical feature being the median, mean, mode, numbered percentile, maximum or minimum panning parameter $\Theta$, and

a target phase difference parameter ($\Phi$), representing a distribution over the time segment of the phase difference between the left and right audio signals (L, R) of the stereo audio signal, wherein the target phase difference parameter ($\Phi$) represents a statistical feature of multiple samples within the time segment, the statistical feature being the median, mean, mode, numbered percentile, maximum or minimum phase difference parameter ($\Phi$);

extracting (S3), for each time segment and each frequency band, a partial mid signal representation (211, 212), wherein the partial mid signal representation (211, 212) is based on a weighted sum of the left and right audio signal (L, R), wherein a weight of each of the left and right audio signals (L, R) is based on at least one of the target panning parameter ($\Theta$) and the target phase difference parameter ($\Phi$) of each frequency band; and

forming (S4) the target mid audio signal (M) by combining the partial mid signal representations (211, 212) for each frequency band and time segment.

2. The method according to claim 1, wherein the weight of the left and right audio signals (L, R) is based on the target panning parameter ($\Theta$) such that the left or right audio signal with a greater magnitude is provided with a greater weight.

3. The method according to claim 1 or 2, wherein the weight of the left and right audio signals (L, R) is complex valued weight, and wherein a phase of the complex valued weight is based on the target phase difference parameter ($\Phi$).

4. The method according to claim 3, wherein the complex valued weight is based on the target phase difference parameter ($\Phi$) and the target panning parameter ($\Theta$) such that the phase difference created by application of the complex weight is lesser for the left or right audio signal with a greater magnitude.

5. The method according to any one of the preceding claims, further comprising:

providing the stereo audio signal to a stereo source separation system (60), configured to output a filter for stereo source separation; and

applying the filter to the target mid audio signal to form a processed target mid audio signal ($M_{sep}$).

6. The method according to any one of the preceding claims, further comprising:

providing the target mid audio signal (M) to a mono source separation system (30) configured to perform audio source separation on a mono audio signal and output a processed mono audio signal; and

using the processed mono audio signal as a processed target mid audio signal ($M_{sep}$).

7. The method according to claim 5 or 6, further comprising

reconstructing processed left and right audio signals (L', R') forming a processed stereo audio signal;

wherein each of the processed left and right audio signals (L', R') is based on the processed target mid audio signal ($M_{sep}$) weighted with a respective left and right weighting factor, wherein the left and right weighting factor is based on at least one of the target panning parameter ($\Theta$) and the target phase difference parameter ($\Phi$) for each time segment and frequency band.

8. The method according to any one of the preceding claims, further comprising:

reconstructing an alternative left and right audio signal ($L_{cen}$, $R_{cen}$) forming an alternative stereo audio signal; and

wherein each of the alternative left and right audio signal ($L_{cen}$, $R_{cen}$) is based on weighted contributions of at least the target mid audio signal, each contribution being based on a respective alternative mid weighting factor, wherein each mid weighting factor is based on at least one of an alternative panning parameter ($\Theta_{cen}$) and an

alternative phase difference parameter ($\Phi_{cen}$), for each time segment and each frequency band.

9. The method according to claim 8, further comprising:

performing stereo signal processing on the alternative stereo audio signal forming a processed alternative stereo audio signal comprising a processed alternative left and right audio signal (L'$_{cen}$, R'$_{cen}$); and
reconstructing a processed target mid audio signals (M'');
wherein the processed target mid audio signal (M') is based on a sum of the processed alternative left and right audio signals (L'$_{cen}$, R'$_{cen}$) weighted with weighting factors,
wherein the weighting factors are based on at least one of the alternative panning parameter ($\Theta_{cen}$) and the alternative phase difference parameter ($\Phi_{cen}$) of each frequency band and time segment.

10. The method according to claim 8 or 9, wherein the alternative panning parameter ($\Theta_{cen}$) and/or phase difference parameter ($\Phi_{cen}$) indicates center panning.

11. The method according to claim 9 or 10, wherein performing stereo signal processing on the alternative stereo audio signal (L$_{cen}$, R$_{cen}$) comprises applying source separation on the alternative stereo audio signal (L$_{cen}$, R$_{cen}$) to output the processed alternative left and right audio signals (L'$_{cen}$, R'$_{cen}$).

12. The method according to any one of the preceding claims, further comprising:

extracting (S31), for each time segment and frequency band, a partial side signal representation (311, 312), wherein the partial side signal representation (311, 312) is based on a weighted difference between the left and right audio signal (L, R), wherein a weight of each of the left and right audio signal (L, R) is based on at least one of the target panning parameter ($\Theta$) and the target phase difference parameter ($\Phi$) of each frequency band and time segment; and
forming (S41) a target side audio signal by combining each partial side signal representation for each frequency band and time segment.

13. The method according to claim 12, further comprising:

performing processing (S5, S51) of at least one of the target mid and target side audio signal (M, S) to form a processed target mid and target side audio signal (M', S');
reconstructing (S6) a processed left and right audio signal (L', R') forming a processed stereo audio signal;
wherein the processed left audio signal (L') is based on a weighted sum of the processed target mid audio signal and target side audio signal (M', S'), wherein the weights are based on at least one of the target panning parameter ($\Theta$) and the target phase difference parameter ($\Phi$), and
wherein the processed right audio signal (R') is based on a weighted difference between the processed target mid audio signal and target side audio signal (M', S'), wherein the weights are based on at least one of the target panning parameter ($\Theta$) and the target phase difference parameter ($\Phi$).

14. The method according to claim 13, wherein performing processing of at least one of the target mid audio signal and target side audio signal (M, S) comprises at least one of:

attenuating the target side audio signal (S);
applying a gain to the target mid audio signal (M);
performing mono signal source separation on the target mid audio signal (M); and
applying stereo source separation filter to the target mid audio signal (M).

15. The method according to any one of the preceding claims, wherein obtaining at least one of: the target panning parameter ($\Theta$) and the target phase difference parameter ($\Phi$), comprises:

obtaining at least one of a plurality of detected panning parameters ($\theta$) and a plurality of detected phase difference parameters ($\phi$);
obtaining, for each detected panning parameter ($\theta$) and detected phase difference parameter ($\phi$) a detected magnitude parameter (U); and
determining at least one of the target panning parameter ($\Theta$) and the target phase difference parameter ($\Phi$) by calculating an average of at least one of the plurality of detected panning parameters ($\theta$) and the plurality of detected phase difference parameters (φ), said average being a weighted average weighted with the detected magnitude parameter (U), and further comprising:

sorting each of said at least one of plurality of detected panning parameters (θ) and a plurality of detected phase difference parameters (φ) into a predetermined number of bins;
wherein each bin is associated with at least one of a detected panning parameter value and a detected phase difference parameter value, and wherein said average of at least one of the plurality of detected panning parameters and the plurality of detected phase difference parameter (φ) is based on the detected panning parameter value and a detected phase difference parameter value.

## Patentansprüche

1. Computerimplementiertes Verfahren zum Extrahieren eines Ziel-Mitten-Audiosignals (M) aus einem Stereo-Audiosignal, wobei das Stereo-Audiosignal ein linkes Audiosignal (L) und ein rechtes Audiosignal (R) umfasst, wobei das Verfahren Folgendes umfasst:

Erhalten (S1) einer Vielzahl von aufeinanderfolgenden Zeitsegmenten des Stereo-Audiosignals, wobei jedes Zeitsegment eine Darstellung eines Abschnitts des Stereo-Audiosignals umfasst;
Erhalten (S2), für jedes Frequenzband einer Vielzahl von Frequenzbändern jedes Zeitsegments des Stereo-Audiosignals, von mindestens einem von:

einem Ziel-Panning-Parameter (Θ), der eine Verteilung über das Zeitsegment der Magnitudendifferenz zwischen dem linken und rechten Audiosignal (L, R) im Frequenzband darstellt, wobei der Ziel-Phasendifferenzparameter (Φ) ein statistisches Merkmal mehrerer Abtastwerte innerhalb des Zeitsegments darstellt, wobei das statistische Merkmal die mediane, mittlere, modale, das nummerierte Perzentil, die maximale oder minimale Phasendifferenz Φ ist, und
ein Zielphasendifferenzparameter (Φ), der eine Verteilung über das Zeitsegment der Phasendifferenz zwischen dem linken und rechten Audiosignal (L, R) des Stereo-Audiosignals darstellt, wobei der Zielphasendifferenzparameter (Φ) ein statistisches Merkmal mehrerer Abtastwerte innerhalb des Zeitsegments darstellt, wobei das statistische Merkmal der mediane, mittlere, modale, das nummerierte Perzentil, der maximale oder minimale Phasendifferenzparameter (Φ) ist;

Extrahieren (S3), für jedes Zeitsegment und jedes Frequenzband, einer Teilmittensignaldarstellung (211, 212), wobei die Teilmittensignaldarstellung (211, 212) auf einer gewichteten Summe des linken und rechten Audiosignals (L, R) basiert, wobei ein Gewicht von jedem des linken und rechten Audiosignals (L, R) auf mindestens einem des Ziel-Panning-Parameters (Θ) und des Ziel-Phasendifferenzparameters (Φ) jedes Frequenzbands basiert; und
Bilden (S4) des Ziel-Mitten-Audiosignals (M) durch Kombinieren der Teilmittensignaldarstellungen (211, 212) für jedes Frequenzband und Zeitsegment.

2. Verfahren nach Anspruch 1, wobei das Gewicht des linken und rechten Audiosignals (L, R) auf dem Ziel-Panning-Parameter (Θ) basiert, so dass dem linken oder rechten Audiosignal mit einer größeren Magnitude ein größeres Gewicht bereitgestellt wird.

3. Verfahren nach Anspruch 1 oder 2, wobei das Gewicht des linken und rechten Audiosignals (L, R) ein komplexwertiges Gewicht ist, und wobei eine Phase des komplexwertigen Gewichts auf dem Ziel-Phasendifferenzparameter (Φ) basiert.

4. Verfahren nach Anspruch 3, wobei das komplexwertige Gewicht auf dem Ziel-Phasendifferenzparameter (Φ) und dem Ziel-Panning-Parameter (Θ) basiert, so dass die durch Anwendung des komplexen Gewichts erzeugte Phasendifferenz für das linke oder rechte Audiosignal mit einer größeren Magnitude geringer ist.

5. Verfahren nach einem der vorstehenden Ansprüche, weiter umfassend:

Bereitstellen des Stereo-Audiosignals an ein Stereo-Quellentrennungssystem (60), konfiguriert zum Ausgeben eines Filters für die Stereo-Quellentrennung; und
Anwenden des Filters auf das Ziel-Mitten-Audiosignal, um ein verarbeitetes Ziel-Mitten-Audiosignal ($M_{sep}$) zu

bilden.

6. Verfahren nach einem der vorstehenden Ansprüche, weiter umfassend:

Bereitstellen des Ziel-Mitten-Audiosignals (M) an ein Mono-Quellentrennungssystem (30), konfiguriert zum Durchführen einer Audioquellentrennung an einem Mono-Audiosignal und zum Ausgeben eines verarbeiteten Mono-Audiosignals; und
Verwenden des verarbeiteten Mono-Audiosignals als ein verarbeitetes Ziel-Mitten-Audiosignal ($M_{sep}$).

7. Verfahren nach Anspruch 5 oder 6, weiter umfassend

Rekonstruieren von verarbeiteten linken und rechten Audiosignalen (L', R'), die ein verarbeitetes Stereo-Audiosignal bilden;
wobei jedes der verarbeiteten linken und rechten Audiosignale (L', R') auf dem verarbeiteten Ziel-Mitten-Audiosignal ($M_{sep}$) basiert, das mit einem jeweiligen linken und rechten Gewichtungsfaktor gewichtet ist, wobei der linke und rechte Gewichtungsfaktor auf mindestens einem des Ziel-Panning-Parameters ($\Theta$) und des Ziel-Phasendifferenzparameters ($\Phi$) für jedes Zeitsegment und Frequenzband basiert.

8. Verfahren nach einem der vorstehenden Ansprüche, weiter umfassend:

Rekonstruieren eines alternativen linken und rechten Audiosignals ($L_{cen}$, $R_{cen}$), die ein alternatives Stereo-Audiosignal bilden; und
wobei jedes der alternativen linken und rechten Audiosignale ($L_{cen}$, $R_{cen}$) auf gewichteten Beiträgen von mindestens dem Ziel-Mitten-Audiosignal basiert, wobei jeder Beitrag auf einem jeweiligen alternativen Mitten-Gewichtungsfaktor basiert, wobei jeder Mitten-Gewichtungsfaktor auf mindestens einem von einem alternativen Panning-Parameter ($\Theta_{cen}$) und einem alternativen Phasendifferenzparameter ($\Phi_{cen}$) für jedes Zeitsegment und jedes Frequenzband basiert.

9. Verfahren nach Anspruch 8, weiter umfassend:

Durchführen einer Stereo-Signalverarbeitung an dem alternativen Stereo-Audiosignal, wodurch ein verarbeitetes alternatives Stereo-Audiosignal gebildet wird, das ein verarbeitetes alternatives linkes und rechtes Audiosignal ($L'_{cen}$, $R'_{cen}$) umfasst; und
Rekonstruieren eines verarbeiteten Ziel-Mitten-Audiosignals (M");
wobei das verarbeitete Ziel-Mitten-Audiosignal (M') auf einer Summe der verarbeiteten alternativen linken und rechten Audiosignale ($L'_{cen}$, $R'_{cen}$) basiert, die mit Gewichtungsfaktoren gewichtet sind,
wobei die Gewichtungsfaktoren auf mindestens einem der alternativen Panning-Parameter ($\Theta_{cen}$) und dem alternativen Phasendifferenzparameter ($\Phi_{cen}$) jedes Frequenzbandes und Zeitsegments basieren.

10. Verfahren nach Anspruch 8 oder 9, wobei der alternative Panning-Parameter ($\Theta_{cen}$) und/oder Phasendifferenzparameter ($\Phi_{cen}$) die Zentrierung angibt.

11. Verfahren nach Anspruch 9 oder 10, wobei Durchführen der Stereo-Signalverarbeitung an dem alternativen Stereo-Audiosignal ($L_{cen}$, $R_{cen}$) Anwenden einer Quellentrennung auf das alternative Stereo-Audiosignal ($L_{cen}$, $R_{cen}$) umfasst, um die verarbeiteten alternativen linken und rechten Audiosignale ($L'_{cen}$, $R'_{cen}$) auszugeben.

12. Verfahren nach einem der vorstehenden Ansprüche, weiter umfassend:

Extrahieren (S31), für jedes Zeitsegment und Frequenzband, einer Teil-Seiten-Signaldarstellung (311, 312), wobei die Teil-Seiten-Signaldarstellung (311, 312) auf einer gewichteten Differenz zwischen dem linken und rechten Audiosignal (L, R) basiert, wobei ein Gewicht von jedem des linken und rechten Audiosignals (L, R) auf mindestens einem des Ziel-Panning-Parameters ($\Theta$) und des Ziel-Phasendifferenzparameters ($\Phi$) jedes Frequenzbands und Zeitsegments basiert; und
Bilden (S41) eines Ziel-Seiten-Audiosignals durch Kombinieren jeder Teil-Seiten-Signaldarstellung für jedes Frequenzband und Zeitsegment.

13. Verfahren nach Anspruch 12, weiter umfassend:

Durchführen einer Verarbeitung (S5, S51) von mindestens einem des Ziel-Mitten- und Ziel-Seiten-Audiosignals (M, S), um ein verarbeitetes Ziel-Mitten- und Ziel-Seiten-Audiosignal (M', S') zu bilden;

Rekonstruieren (S6) eines verarbeiteten linken und rechten Audiosignals (L', R'), die ein verarbeitetes Stereo-Audiosignal bilden;

wobei das verarbeitete linke Audiosignal (L') auf einer gewichteten Summe des verarbeiteten Ziel-Mitten-Audiosignals und Ziel-Seiten-Audiosignals (M', S') basiert, wobei die Gewichte auf mindestens einem des Ziel-Panning-Parameters (Θ) und des Ziel-Phasendifferenzparameters (Φ) basieren, und

wobei das verarbeitete rechte Audiosignal (R') auf einer gewichteten Differenz zwischen dem verarbeiteten Ziel-Mitten-Audiosignal und Ziel-Seiten-Audiosignal (M', S') basiert, wobei die Gewichte auf mindestens einem des Ziel-Panning-Parameters (Θ) und des Ziel-Phasendifferenzparameters (Φ) basieren.

14. Verfahren nach Anspruch 13, wobei Durchführen der Verarbeitung von mindestens einem des Ziel-Mitten-Audiosignals und Ziel-Seiten-Audiosignals (M, S) mindestens eines umfasst von:

Abschwächen des Ziel-Seiten-Audiosignals (S);
Anwenden einer Verstärkung auf das Ziel-Mitten-Audiosignal (M);
Durchführen einer Mono-Signal-Quellentrennung an dem Ziel-Mitten-Audiosignal (M); und
Anwenden eines Stereo-Quellentrennung-Filters auf das Ziel-Mitten-Audiosignal (M).

15. Verfahren nach einem der vorstehenden Ansprüche, wobei Erhalten von mindestens einem von: dem Ziel-Panning-Parameter (Θ) und dem Ziel-Phasendifferenzparameter (Φ), umfasst:

Erhalten von mindestens einem von einer Vielzahl detektierter Panning-Parameter (θ) und einer Vielzahl detektierter Phasendifferenzparameter (φ);
Erhalten eines detektierten Magnitudenparameters (U) für jeden detektierten Panning-Parameter (θ) und detektierten Phasendifferenzparameter (φ); und
Bestimmen von mindestens einem des Ziel-Panning-Parameters (Θ) und des Ziel-Phasendifferenzparameters (Φ) durch Berechnen eines Mittelwerts von mindestens einem der Vielzahl von detektierten Panning-Parametern (θ) und der Vielzahl von detektierten Phasendifferenzparametern (φ), wobei der Mittelwert ein gewichteter Mittelwert ist, der mit dem detektierten Magnitudenparameter (U) gewichtet ist, und weiter umfassend:

Sortieren jedes von dem mindestens einen der Vielzahl von detektierten Panning-Parametern (θ) und der Vielzahl von detektierten Phasendifferenzparametern (φ) in eine vorbestimmte Anzahl von Bins;
wobei jedem Bin mindestens eines von einem detektierten Panning-Parameterwert und einem detektierten Phasendifferenzparameterwert zugeordnet ist, und wobei der Mittelwert von mindestens einem der Vielzahl von detektierten Panning-Parametern und der Vielzahl von detektierten Phasendifferenzparameternr (φ) auf dem detektierten Panning-Parameterwert und einem detektierten Phasendifferenzparameterwert basiert.

**Revendications**

1. Procédé informatique d'extraction d'un signal audio cible Mid (M) à partir d'un signal audio stéréo, ce dernier comprenant un signal audio gauche (L) et un signal audio droit (R), ledit procédé comprenant :

l'obtention (S1) d'une pluralité de segments temporels consécutifs du signal audio stéréo, dans lequel chaque segment temporel comprend une représentation d'une partie du signal audio stéréo ;
l'obtention (S2), pour chaque bande de fréquence d'une pluralité de bandes de fréquence de chaque segment temporel du signal audio stéréo, d'au moins l'un de :

un paramètre de panoramique cible (Θ), représentant une distribution sur le segment temporel d'un rapport d'amplitude entre les signaux audio gauche et droit (L, R) dans la bande de fréquence, dans lequel le paramètre de panoramique cible (Θ) représente une caractéristique statistique de plusieurs échantillons au sein du segment temporel, la caractéristique statistique étant la médiane, la moyenne, le mode, le percentile numérique, le paramètre de panoramique maximal ou minimal Θ, et
un paramètre de différence de phase cible (Φ), représentant une distribution sur le segment temporel de la différence de phase entre les signaux audio gauche et droit (L, R) du signal audio stéréo, dans lequel le paramètre de différence de phase cible (Φ) représente une caractéristique statistique de plusieurs échantillons dans le segment temporel, la caractéristique statistique étant la médiane, la moyenne, le mode, le percentile numéroté, le paramètre de différence de phase maximum ou minimum ($\Phi$) ;

l'extraction (S3), pour chaque segment temporel et chaque bande de fréquence, d'une représentation partielle du signal Mid (211, 212), dans laquelle la représentation partielle du signal Mid (211, 212) est basée sur une somme pondérée des signaux audio gauche et droit (L, R), dans laquelle un poids de chacun des signaux audio gauche et droit (L, R) est basé sur au moins un des paramètres de panoramique cible ($\Theta$) et de différence de phase cible ($\Phi$) de chaque bande de fréquence ; et

la formation (S4) du signal audio cible Mid (M) en combinant les représentations partielles du signal médian (211, 212) pour chaque bande de fréquence et segment temporel.

2. Procédé selon la revendication 1, dans lequel le poids des signaux audio gauche et droit (L, R) est basé sur le paramètre de panoramique cible ($\Theta$) de sorte que le signal audio gauche ou droit de plus grande amplitude se voit attribuer un poids plus important.

3. Procédé selon la revendication 1 ou 2, dans lequel le poids des signaux audio gauche et droit (L, R) est un poids à valeur complexe, et dans lequel une phase du poids à valeur complexe est basée sur le paramètre de différence de phase cible ($\Phi$).

4. Procédé selon la revendication 3, dans lequel le poids à valeur complexe est basé sur le paramètre de différence de phase cible ($\Phi$) et le paramètre de panoramique cible ($\Theta$) de sorte que la différence de phase créée par l'application du poids complexe soit moindre pour le signal audio gauche ou droit avec une plus grande amplitude.

5. Procédé selon l'une quelconque des revendications précédentes, comprenant en outre :

la fourniture du signal audio stéréo à un système de séparation de sources stéréo (60), configuré pour produire un filtre de séparation de sources stéréo ; et
l'application du filtre au signal audio cible Mid pour former un signal audio cible Mid traité ($M_{sep}$).

6. Procédé selon l'une quelconque des revendications précédentes, comprenant en outre :

la fourniture du signal audio cible Mid (M) à un système de séparation de sources mono (30) configuré pour effectuer la séparation de sources audio sur un signal audio mono et produire un signal audio mono traité ; et
l'utilisation du signal audio mono traité comme signal audio cible Mid traité ($M_{sep}$).

7. Procédé selon la revendication 5 ou 6, comprenant en outre

la reconstruction des signaux audio gauche et droit traités (L', R') formant un signal audio stéréo traité ;
dans lequel chacun des signaux audio gauche et droit traités (L', R') est basé sur le signal audio cible Mid traité ($M_{sep}$) pondéré avec un facteur de pondération gauche et droit respectif, dans lequel le facteur de pondération gauche et droit est basé sur au moins un des paramètres de panoramique cible ($\Theta$) et le paramètre de différence de phase cible ($\Phi$) pour chaque segment temporel et bande de fréquence.

8. Procédé selon l'une quelconque des revendications précédentes, comprenant en outre :

la reconstruction d'un signal audio alternatif gauche et droit ($L_{cen}$, $R_{cen}$) formant un signal audio stéréo alternatif ; et
dans lequel chacun des signaux audio alternatifs gauche et droit ($L_{cen}$, $R_{cen}$) est basé sur des contributions pondérées d'au moins le signal audio cible Mid, chaque contribution étant basée sur un facteur de pondération Mid alternatif respectif, où chaque facteur de pondération Mid est basé sur au moins un paramètre de panoramique alternatif ($\Theta_{cen}$) et un paramètre de différence de phase alternatif ($\Phi_{cen}$), pour chaque segment temporel et chaque bande de fréquence.

9. Procédé selon la revendication 8, comprenant en outre :

la réalisation d'un traitement du signal stéréo sur le signal audio stéréo alternatif, formant ainsi un signal audio stéréo alternatif traité comprenant un signal audio gauche et un signal audio droit alternatifs traités ($L'_{cen}$, $R'_{cen}$) ; et
la reconstruction d'un signal audio cible Mid traité (M") ;

dans lequel le signal audio cible Mid traité (M') est basé sur une somme des signaux audio alternatifs gauche et droit traités (L'$_{cen}$, R'$_{cen}$) pondérés par des facteurs de pondération,

dans lequel les facteurs de pondération sont basés sur au moins un des paramètres de panoramique alternatif ($\Theta_{cen}$) et le paramètre de différence de phase alternatif ($\Phi_{cen}$) de chaque bande de fréquence et segment temporel.

10. Procédé selon la revendication 8 ou 9, dans lequel le paramètre de panoramique alternatif ($\Theta_{cen}$) et/ou le paramètre de différence de phase ($\Phi_{cen}$) indique le panoramique central.

11. Procédé selon la revendication 9 ou 10, dans lequel l'exécution du traitement du signal stéréo sur le signal audio stéréo alternatif (L$_{cen}$, R$_{cen}$) comprend l'application d'une séparation de source sur le signal audio stéréo alternatif (L$_{cen}$, R$_{cen}$) pour produire les signaux audio gauche et droit alternatifs traités (L'$_{cen}$, R'$_{cen}$).

12. Procédé selon l'une quelconque des revendications précédentes, comprenant en outre :

l'extraction (S31), pour chaque segment temporel et bande de fréquence, d'une représentation partielle du signal latéral (311, 312), dans laquelle la représentation partielle du signal latéral (311, 312) est basée sur une différence pondérée des signaux audio gauche et droit (L, R), dans laquelle un poids de chacun des signaux audio gauche et droit (L, R) est basé sur au moins un des paramètres de panoramique cible ($\Theta$) et de différence de phase cible ($\Phi$) de chaque bande de fréquence et segment temporel ; et

la formation (S41) d'un signal audio côté cible en combinant chaque représentation partielle du signal côté pour chaque bande de fréquence et segment temporel.

13. Procédé selon la revendication 12, comprenant en outre :

la réalisation du traitement (S5, S51) d'au moins un des signaux audio cibles Mid et latéral (M, S) pour former un signal audio cible Mid et latéral traité (M', S') ;

la reconstruction (S6) d'un signal audio gauche et droit traité (L', R') formant un signal audio stéréo traité ;

dans lequel le signal audio gauche traité (L') est basé sur une somme pondérée du signal audio cible Mid traité et du signal audio latéral cible (M', S'), dans lequel les pondérations sont basées sur au moins un des paramètres de panoramique cible ($\Theta$) et de différence de phase cible ($\Phi$), et

dans lequel le signal audio droit traité (R') est basé sur une différence entre le signal audio cible Mid traité et du signal audio latéral cible (M', S'), dans lequel les pondérations sont basées sur au moins un des paramètres de panoramique cible ($\Theta$) et de différence de phase cible ($\Phi$).

14. Procédé selon la revendication 13, dans lequel le traitement d'au moins un des signaux audio cibles Mid et latéral (M, S) comprend au moins une des opérations suivantes :

l'atténuation du signal audio côté cible (S) ;

l'application d'un gain au signal audio cible Mid (M) ;

la réalisation de la séparation de sources de signaux mono sur le signal audio cible Mid (M) ; et

l'application d'un filtre de séparation de source stéréo au signal audio cible Mid (M).

15. Procédé selon l'une quelconque des revendications précédentes, dans lequel l'obtention d'au moins un des paramètres suivants : le paramètre de panoramique cible ($\Theta$) et le paramètre de différence de phase cible ($\Phi$), comprend :

l'obtention d'au moins un des paramètres de panoramique détectés ($\theta$) et un des paramètres de différence de phase détectés ($\varphi$);

l'obtention, pour chaque paramètre de panoramique détecté ($\theta$) et paramètre de différence de phase détecté ($\varphi$), d'un paramètre d'amplitude détecté (U) ; et

la détermination d'au moins un du paramètre de panoramique cible ($\Theta$) et du paramètre de différence de phase cible ($\Phi$) en calculant une moyenne d'au moins un des paramètres de panoramique détectés ($\theta$) et des paramètres de différence de phase détectés ($\varphi$), ladite moyenne étant une moyenne pondérée par le paramètre d'amplitude détecté (U), et comprenant en outre :

le tri de chacun d'au moins une pluralité des paramètres de panoramique détectés ($\theta$) et d'une pluralité des paramètres de différence de phase détectés ($\varphi$) dans un nombre prédéterminé de classes ;

dans lequel chaque classe est associée à au moins une valeur de paramètre de panoramique détectée et une valeur de paramètre de différence de phase détectée, et dans lequel ladite moyenne d'au moins un des paramètres de panoramique détectés et des paramètres de différence de phase détectés ($\varphi$) est basée sur la valeur du paramètre de panoramique détectée et une valeur du paramètre de différence de phase détectée.

M

| M$_{(t,1)}$ |
| M$_{(t,2)}$ |
| ○○○ |
| M$_{(t,B)}$ |

$$\underline{10}$$

M/S EXTRACTOR

12

L, R →

111

| Θ$_{(t,1)}$, Φ$_{(t,1)}$ |
| Θ$_{(t,2)}$, Φ$_{(t,2)}$ |
| ○○○ |
| Θ$_{(t,B)}$, Φ$_{(t,B)}$ |

112

100 →

| S$_{(t,1)}$ |
| S$_{(t,2)}$ |
| ○○○ |
| S$_{(t,B)}$ |

S

**FIG. 1**

S1 — OBTAINING STEREO AUDIO SIGNAL

S2 — OBTAINING TARGET PANNING PARAMETER AND/OR PHASE DIFFERENCE PARAMETERS

S3 — EXTRACTING PARTIAL MID AUDIO SIGNAL REPRESENTATION

S31 — EXTRACTING PARTIAL SIDE AUDIO SIGNAL REPRESENTATION

S4 — FORMING TARGET MID AUDIO SIGNAL

S41 — FORMING TARGET SIDE AUDIO SIGNAL

S5 — PERFORMING MID PROCESSING

S51 — PERFORMING SIDE PROCESSING

S6 — RECONSTRUCTING PROCESSED STEREO AUDIO SIGNAL

**FIG. 2**

10'

L, R

14 — PARAMETER EXTRACTOR

M/S EXTRACTOR

12

$\Theta_{(t,1)}, \Phi_{(t,1)}$ — 111

$\Theta_{(t,2)}, \Phi_{(t,2)}$ — 112

$\Theta_{(t,B)}, \Phi_{(t,B)}$ — 100

M

$M_{(t,1)}$

$M_{(t,2)}$

$M_{(t,B)}$

$S_{(t,1)}$

$S_{(t,2)}$

$S_{(t,B)}$

L

S

**FIG. 3**

100

110    120

B

111    121

| $\Theta_{(1,1)}, \Phi_{(1,1)}$ | $\Theta_{(2,1)}, \Phi_{(2,1)}$ | ∘ ∘ ∘ | $\Theta_{(t,1)}, \Phi_{(t,1)}$ |
|---|---|---|---|
| $\Theta_{(1,2)}, \Phi_{(1,2)}$ | $\Theta_{(2,2)}, \Phi_{(2,2)}$ | ∘ ∘ ∘ | $\Theta_{(t,2)}, \Phi_{(t,2)}$ |
| 112 ∘∘ | 122 ∘∘ | ∘ ∘ ∘ | ∘∘ |
| $\Theta_{(1,B)}, \Phi_{(1,B)}$ | $\Theta_{(2,B)}, \Phi_{(2,B)}$ | ∘ ∘ ∘ | $\Theta_{(t,B)}, \Phi_{(t,B)}$ |

t

**FIG. 4a**

| 210 | 220 221 | | 200 |
|---|---|---|---|
| $M_{(1,1)}$ | $M_{(2,1)}$ | o o o | $M_{(t,1)}$ |
| $M_{(1,2)}$ | $M_{(2,2)}$ | o o o | $M_{(t,2)}$ |
| o o o | 222 o o o | o o o | o o o |
| $M_{(1,B)}$ | $M_{(2,B)}$ | o o o | $M_{(t,B)}$ |
| $M_{(1)}$ | $M_{(2)}$ | o o o | $M_{(t)}$ |

M

## FIG. 4b

| 310 | 320 321 | | 300 |
|---|---|---|---|
| $S_{(1,1)}$ | $S_{(2,1)}$ | o o o | $S_{(t,1)}$ |
| $S_{(1,2)}$ | $S_{(2,2)}$ | o o o | $S_{(t,2)}$ |
| o o o | 322 o o o | o o o | o o o |
| $S_{(1,B)}$ | $S_{(2,B)}$ | o o o | $S_{(t,B)}$ |
| $S_{(1)}$ | $S_{(2)}$ | o o o | $S_{(t)}$ |

S

## FIG. 4c

FIG. 5a

FIG. 5b

FIG. 6a

FIG. 6b

FIG. 6c

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 63318226
- US 63423786
- EP 22183794
- WO 2021252795 A2

### Non-patent literature cited in the description

- Stereo Music Source Separation via Bayesian Modeling. **MASTER, AARON**. Ph.D. dissertation. Stanford University, 2006
- **SEBASTIAN KRAFT et al.** STEREO SIGNAL SEPARATION AND UPMIXING BY MID-SIDE DECOMPOSITION IN THE FREQUENCY-DOMAIN. *Proc. of the 18th Int. Conference on Digital Audio Effects (DAFx-15), Trondheim, Norway*
- Loudness Concepts & Pan Laws. **ANDERS ØLAND**; **ROGER DANNENBERG**. Introduction to Computer Music. Carnegie Mellon University
- **MASTER, A**. Dialog Enhancement via Spatio-Level Filtering and Classification. *Convention Paper 10427 of the 149th Convention of the Audio Engineering Society*